# EUROPEAN PATENT SPECIFICATION

(11) **EP 0 334 052 B1**
(45) Date of publication and mention of the grant of the patent: **11.08.1993**
(21) Application number: 89103360.7
(22) Date of filing: 25.02.1989
(51) Int. Cl.: H01L 29/78

(54) **Thin film transistor**
Dünnfilm-Transistor
Transistor couche mince

(30) Priority: 22.03.1988 US 171605
(43) Date of publication of application: 27.09.1989
(73) Proprietor: International Business Machines Corporation, Armonk, N.Y. 10504 (US)
(72) Inventor: Batey, John, Croton, N.Y. 10620 (US); Joshi, Raily V., Yorktown Heights N.Y. 10598 (US)
(74) Representative: Mönig, Anton, Dipl.-Ing.

(56) References cited:
- EP-A- 0 068 897
- EP-A- 0 164 976
- EP-A- 0 197 531
- EP-A- 0 329 482
- RCA REVIEW, volume 31, no. 2, June 1970, pages 306-316; J.M. SHAW et al.: "Vapor-deposited tungsten as a metallization and interconnection material for silicon devices"
- SOLID STATE TECHNOLOGY, vol. 27, no. 5, May 1984, pages 155-161, Port Washington, New York, US; S.T. MASTROIANNI: "Multilevel metallization device structures and process options"

## Description

This invention relates to thin film transistors and more particularly, to amorphous silicon, thin film field effect transistors having metallic source/drain regions with low resistance.

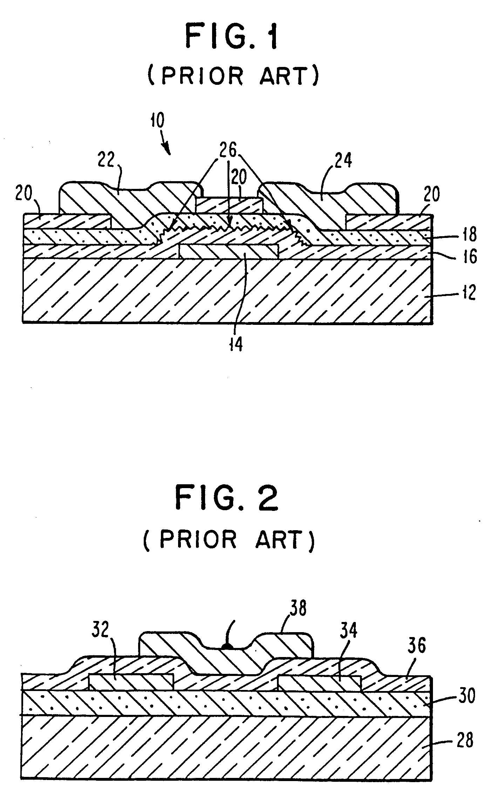

Thin film transistor technology is now the preferred technology for use in active element addressing of large area flat panel displays. A plurality of switching elements each made up of a thin film transistor are formed on an insulating substrate in a matrix configuration. The matrix of thin film transistors are used as switching elements for pixels in liquid crystal, electroluminescence and electrochromic flat panel display devices. In the manufacture of flat panel displays, the cost of silicon or quartz substrates is quite high. This is especially true for large displays having dimensions greater than 14 inches. Thus, in order to reduce manufacturing costs, simple glass substrates have been investigated to replace silicon. However, the use of glass may present a problem when polysilicon is used as a semiconductor material in the thin film transistor. Typically, polysilicon requires deposition temperatures of 600°C which may adversely affect the glass to the point where it would begin to melt. For this reason, amorphous silicon is being widely researched as a semiconductor layer in the thin film transistors with glass substrates. The amorphous silicon layer is formed by plasma enhanced chemical vapor deposition techniques at temperatures of 350°C or less, which can generally be tolerated by the glass. Nevertheless, several drawbacks have developed in the fabrication of the prior art thin film amorphous silicon transistors. One of the main difficulties in this technology is the formation of low resistance metallic contacts to the intrinsic amorphous silicon region. A second problem that has arisen is with regard to the series resistance associated with the bulk amorphous silicon. The aforementioned and other drawbacks of the prior art devices will be more fully described with reference to Figures 1 and 2.

Figure 1 is a cross-sectional view of an inverted gate thin film transistor 10 having a substrate 12 and a metal gate 14 disposed thereon. An insulator layer 16 is disposed on the substrate 12 and gate 14. A layer of semiconductor material 18 is disposed on the insulator layer 16. A second insulator layer 20 is disposed on the semiconductor layer 18 and source and drain electrodes 22 and 24 are deposited in vias etched in the insulator layer 20.

The thin film transistor shown in Figure 1 operates as an inverted gate field effect transistor by applying a voltage to the gate electrode 14. The application of the voltage causes a channel, indicated at 26, to be formed between the source electrode 22 and drain electrode 24 at the interface of the insulator layer 16 and the semiconductor layer 18. In the inverted gate structure of Figure 1, the source and drain contacts 22, 24 are spaced from the channel 26 by a distance equal to the semiconductor layer thickness, which is generally in the range of 2000 angstroms 10 angtroms = 1nm. This spacing represents a significant additional resistance on the order of several meg ohms in the transistor which adversely affects device performance. In the prior art, the formation of the source and drain electrodes within the semiconductor layer could only be accomplished with the high temperature processes of ion implantation and diffusion. As stated above, high temperatures are not desirable when using glass substrates. In addition, if amorphous silicon is used as the semiconductor material, the resulting device would not function since the high temperatures involved in the ion implantation and diffusion would drive off the included hydrogen and the properties of the amorphous silicon would be lost. EP-A-0 197 591 shows the use of a refractory metal silicide for source and drain electrodes in thin film transistors.

Figure 2 shows a cross-sectional view of a non-inverted gate thin film transistor having a glass substrate 28 and a semiconductor layer 30 disposed thereon. Source and drain contacts 32 and 34 are deposited on the semiconductor layer 30 and a gate insulator layer 36 is deposited over the semiconductor layer 30 and source and drain contacts 32 and 34. A metallic gate electrode 38 is deposited on the insulator layer 36 to complete the device. Similar channel contact problems exist in the device of Figure 2 as corner field effects inhibit contact and increase the resistance.

In addition, the fabrication of thin film FETs requires an alignment of the gate with the source and drain electrodes. As shown in Figure 2, a portion of the gate 38 overlaps the source and drain electrodes. Critical alignment steps are necessary to ensure the gate sufficiently overlaps the source and drain electrode. This overlap is necessary in order to provide high transconductance between the source and drain electrodes. However, the source to gate and drain to gate overlaps are limited in extent to prevent the formation of large source to gate and drain to gate capacitances, which would create undesirable parasitic capacitances.

Accordingly, optimum FET performance has been achieved through stringent alignment of the metal electrode to the source and drain electrodes. This is especially true in the fabrication of a display system where small parasitics cannot be tolerated. In a practical manufacturing environment, such a stringent alignment requirement is not easily complied with. Alignment for devices formed on large glass substrates are particularly difficult as the glass tends to warp during processing so that transistors aligned on one area of the substrate will be misaligned on another area of the substrate. As a consequence, a typical manufacturing yield of a batch of thin film FETs tends to be lower than desirable.

Moreover, as with the device of Figure 1, attempts to build devices having the source and drain formed within the semiconductor layer that encroach beneath the gate have been unsuccessful when using amorphous silicon on a glass substrate. Encroachment is effected by ion implantation by diffusion which destroys the amorphous silicon properties.

The present invention is directed to a thin film field effect transistors in which the source and drain electrodes make direct contact with the channel region. In addition, the invention is directed a thin film field effect transistors having self-aligned source and drain electrodes with the gate electrode. The unique features of the invention are disclosed in both inverted gate and non-inverted gate type FETs. In addition, the invention is directed to a novel method of fabricating the inventive devices in which source and drain electrodes are formed within the semiconductor layer of a metallic material.

The thin film inverted gate FET of the present invention comprises a gate electrode layer disposed on a substrate. A first insulator layer is disposed on the substrate and the gate electrode. A semiconductor layer is disposed on the insulator layer and source and drain electrodes are formed within the semiconductor layer that substantially contact the channel region above the gate. The source and drain electrodes are spaced apart in the region above the gate electrode. The source and drain electrodes are formed by a unique metal reduction process that will be described in detail hereinafter. A second insulator layer is disposed on the semiconductor layer extending across the region between the source and drain electrodes. The inverted gate thin film FET of the invention overcomes the deficiences of the prior art. In operation, upon switching on the channel by a suitable gate voltage, the direct or near direct contact of the source and drain electrodes to the channel region of high electron concentration results in a significant reduction in the resistance.

The non-inverted thin film FET of the present invention comprises a semiconductor layer disposed on a substrate. The gate insulator layer is disposed on a semiconductor layer and the gate electrode layer is disposed on the gate insulator layer. Source and drain electrodes are formed within the semiconductor layer such that the source and drain electrodes are spaced apart in a portion of the region below the gate insulator layer. As with the inverted gate transistor described above, the non-inverted gate thin film FET of the invention overcomes the deficiences of the prior art in that the contact afforded by the source and drain regions to the channel should be of a suitably low resistance once the channel is switched on.

The source and drain electrodes, for both the inverted and non-inverted gate thin film FETs of the invention are fabricated by using a metal hexafluoride gas reduction process to convert the source and drain regions of the semiconductor layer in each device to a refractory metal. Specifically, the process utilized is that disclosed in U.S. Patent Application Serial No. 157 026 of R.V. Joshi (hereinafter referred to as the Joshi process), one of the co-inventors herein. This process is also known from EP-A-0 164 976. The aforementioned Joshi application has been assigned to the same assignee as the present application and is incorporated herein by reference. The Joshi process is a non-self-limiting refractory metal reduction process whereby a semiconductor layer is exposed to a metal hexafluoride gas under conditions of flow rate, pressure and temperature sufficient to render the reaction no longer self-limiting. In accordance with the process, silicon, whether in a monocrystalline, polycrystalline or amorphous state, can be converted to a metal such as tungsten, in accordance with the reaction:

2WF₆ + 3Si → 2W + 3SiF₄ ↑

Pursuant to the Joshi process, by adjusting the chemical vapor deposition conditions under which the WF₆ gas is exposed to the silicon, such as flow rate, pressure and temperature, a thickness of semiconductor material larger than at which the reaction was previously known to be self-limiting, can now be completely converted to tungsten. The reaction can be performed at low temperatures, such as 350°C or less, and the resulting tungsten will have relatively low resistivity. Alternatively, the good control which can be achieved by this process can be used to stop the reaction after a predetermined depth of conversion. Thus, in the case of the inverted gate thin film FET, the electrodes may be formed in the semiconductor layer while leaving a small buffer region separating the channel. This near direct contact will avoid possible high field of problems in the gate-insulator-source/drain regions, but still maintain good channel contact. In addition, the reaction is essentially 100% selective in that insulator materials such as SiO₂ and Si₃N₄ do not react at all and can be used as a mask for delineation.

The use of the Joshi process to form the source and drain electrodes within the semiconductor layer of the structures results in self-aligned source to gate and drain to gate overlaps. Portions of the semiconductor material on both sides of the channel region are completely converted to tungsten. In carrying out the conversion, the tungsten is caused to encroach under the gate oxide because the conversion is isotropic, i.e., the conversion of silicon to tungsten goes as wide as it does deep. In this way, the width of the channel region can be easily controlled. No expedients, such as gate sidewalls, are required since the silicon is directly converted to tungsten in a self-aligned manner.

The direct channel contact and self-aligned TFTs of the present invention are made possible by the use of the Joshi low temperature, non-self limiting process. This is especially advantageous in the fabrication of a matrix of active elements for flat panel displays utilizing glass substrates which tend to distort during device fabrication. Thus, the effective yield of the thin film FETs in accordance with the invention is greatly increased over the prior art.

The invention is described in detail with reference to the drawings in which:
Figure 1 is a schematic cross-sectional view of a prior art inverted gate thin film field effect transistor.
Figure 2 is a schematic cross-sectional view of a prior art thin film non-inverted gate field effect transistor.
Figures 3a - 3d are schematic cross-sectional views of an inverted gate thin film FET of the present invention showing sequentially the major fabrication steps.
Figures 3e - 3h are schematic cross-sectional views of an inverted gate thin film FET of the present invention showing alternative embodiments of fabrication.
Figures 4a - 4c are schematic cross-sectional views of a non-inverted thin film FET of the present invention showing sequentially the major fabrication steps.
Figures 5a and 5b are schematic cross-sectional views of a non-inverted gate thin film FET of the present invention showing sequentially the major fabrication steps of an alternative embodiment.

The present invention is directed to thin film field effect transistors of both the inverted gate and non-inverted gate type which have direct or near direct contact of the source and drain electrodes to the channel region. In addition, in fabricating one type of thin film FET of the invention, the source and drain electrodes are formed within the semiconductor layer by a method which provides self-alignment with the gate electrode. The direct or near direct contact with the channel region significantly reduces the series resistance present in prior art devices thereby enhancing device performance. The self-alignment significantly reduces production costs especially when several hundred thin film FETs of the invention are fabricated on a large glass substrate for use in a flat panel display.

The fabrication of the thin film transistors (TFT) of the present invention utilizes the aforementioned Joshi non-self-limiting metal hexafluoride reduction process. This process, disclosed in U.S. Patent Application Serial No. 157 026 and incorporated herein by reference, converts semiconductor material to a refractory metal in a CVD process by exposing the semiconductor to a metal hexafluoride gas under conditions of flow rate, pressure and temperature sufficient to render the reaction non-self-limiting. Thus, in accordance with the Joshi process, thicknesses of silicon, whether monocrystalline, polycrystalline, or amorphous, greater than the thickness at which the reduction process was heretofore known to be self-limiting, may be fully converted to a refractory metal such as tungsten in accordance with the reaction:

2WF₆ + 3Si → 2W + 3SiF₄ ↑ (1)

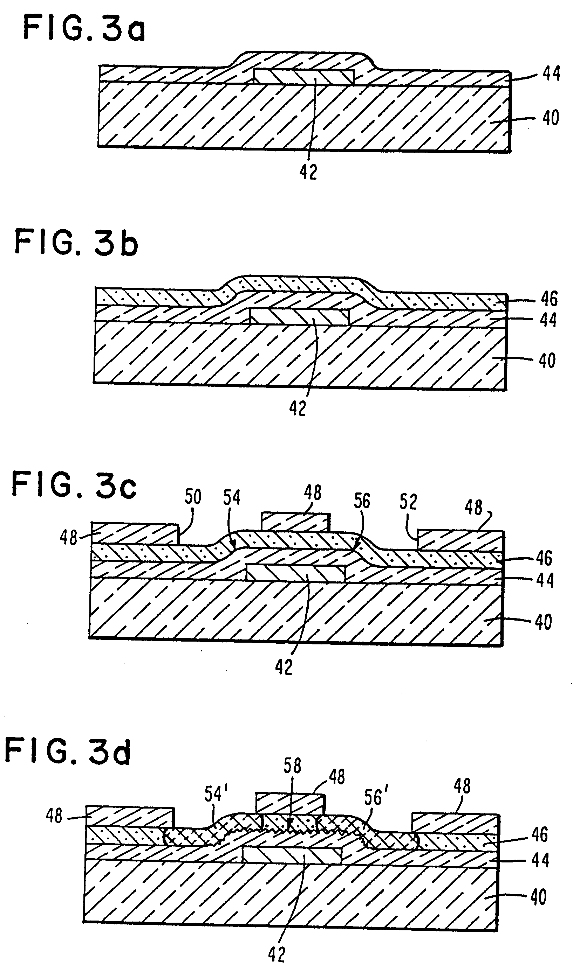

Referring now to the drawings, Figures 3a - 3d, show the basic fabrication steps for forming an inverted gate TFT of the present invention. As shown in Figure 3a, an insulating substrate 40 is provided with a metal gate 42 and a insulator layer 44 disposed on the substrate 40 and the gate 42. The insulating substrate 40 may be made of any undoped semiconductor material or of glass, such as Corning 7059. The metal gate pattern is defined by standard techniques such as by sputtering or evaporation and photolithography. Any metal suitable for operating as a gate conductor may be utilized, such as, Mo, Ni, Cr, NiCr, Al, CrCu, and MoTa. The insulator layer 44 is deposited thereon by any known deposition method, such as chemical vapor deposition.

As shown in Figure 3b, a layer of semiconductor material 46 is deposited onto the insulator layer 44. The semiconductor layer is also deposited by standard deposition techniques. The semiconductor material in the illustrative embodiment of the present invention is made of silicon and may be in a monocrystalline state, a polycrystalline state or an amorphous state. For purposes of fabricating a large flat panel display, where the substrate 40 is made of glass, the preferred material for semiconductor layer 46 is amorphous silicon. Amorphous silicon is deposited by using silane gas and hence the layer 46 will be hydrogenated. This deposition can take place in temperatures of 350°C or less which are conditions favorable to the glass substrate.

As shown in Figure 3c, a second layer of insulator material 48 is deposited on the semiconductor layer 46 and vias 50 and 52 are etched by any known technique such as dry or wet etching to expose source and drain regions 54 and 56 of the semiconductor layer 46. The structure shown in Figure 3c is then exposed to the metal hexafluoride gas in accordance with the aforementioned Joshi process to selectively convert the regions 54 and 56 to a refractory metal. In the illustrative embodiment of the invention as shown in Figure 3d, the regions 54 and 56 are fully converted to the refractory metal, such as tungsten, so that the regions form source and drain electrodes 54′ and 56′ that contact the channel region 58. A portion of the layer 46 extending over the metal gate 58 will be converted to tungsten as shown in Figure 3d. The thickness of the layers may vary widely pursuant to the particular application. As the Joshi process is non-self limiting, there is no limitation on the thickness of the semiconductor material to be converted.

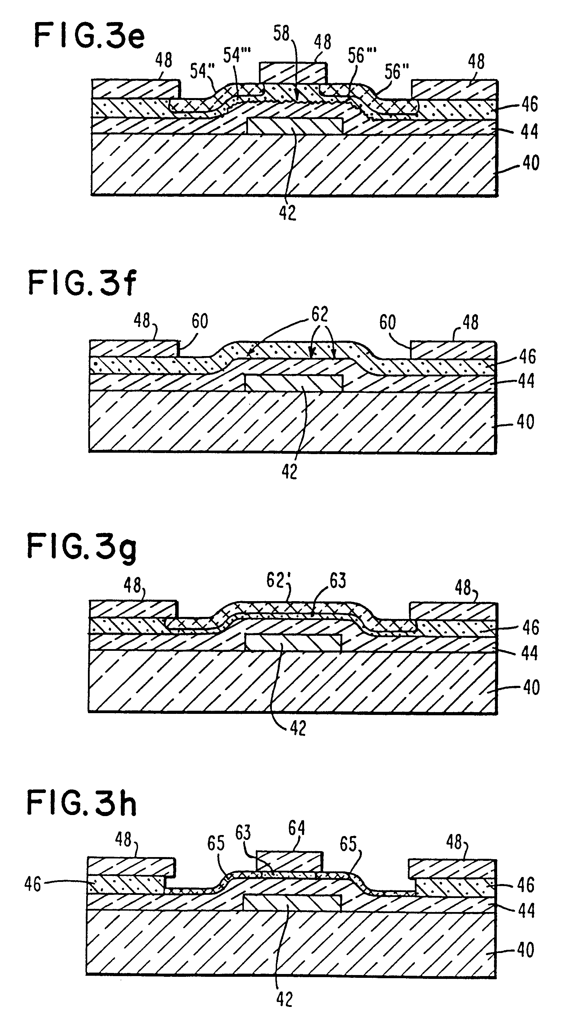

Alternatively, the depth of conversion of the regions 54 and 56 may be controlled by adjusting process parameters including the time of the reaction to stop the reaction after a predetermined depth of conversion. As shown in Fig. 3e, a spacing 54‴ and 56‴ is provided between the refractory metal electrodes 54˝ and 56˝ and the channel region 58. This spacing should be less than 500 angstroms and may be as small as 100 angstroms. The spacing would avoid possible high field problems in the gate insulator-source/drain regions while still maintaining good channel contact.

In operation, once the channel is switched on by a suitable gate voltage, the direct or near direct contact by the refractory metal electrodes to the channel region of high electron concentration will result in a suitably low resistance. The resistance will be substantially less than the 4 meg ohms of the prior art device described above. Depending on the application and thickness of material converted to the metal source/drain electrodes, the resistance will be reduced to negligible amounts. By eliminating the spacing in the prior art TFTs between the source and drain electrodes and the channel region in the amorphous silicon semiconductor layer, the bulk resistance of the amorphous silicon is no longer a significant factor. Thus, the use of the Joshi process to form the source and drain electrodes within the amorphous silicon layer significantly enhances device performance.

An alternative embodiment is shown in Figures 3f - 3h wherein after the device of 3b is formed, one large area via 60 is etched as shown in Figure 3f. The entire substrate is then exposed to the refractory metal hexafluoride gas in accordance with the Joshi process to convert less than the full depth of the region 62 to the refractory metal 62′. As shown in Figure 3g, an unconverted region 63 remains amorphous silicon. All of the metallic region 62′ is then etched away and an insulator layer 64 is deposited above the gate 42. The remaining exposed unconverted amorphous silicon region 63 is converted by the Joshi process to a refractory metal 65, such as tungsten, as shown in Figure 3h. Thus, the remaining amorphous silicon region 63 in the device is selectively thinner thereby reducing adverse photoconductivity effects. In addition, the thickness of amorphous silicon 46, surrounding the device, remains at the original thickness which is desirable in a flat panel display application to prevent short circuiting of the gate metal.

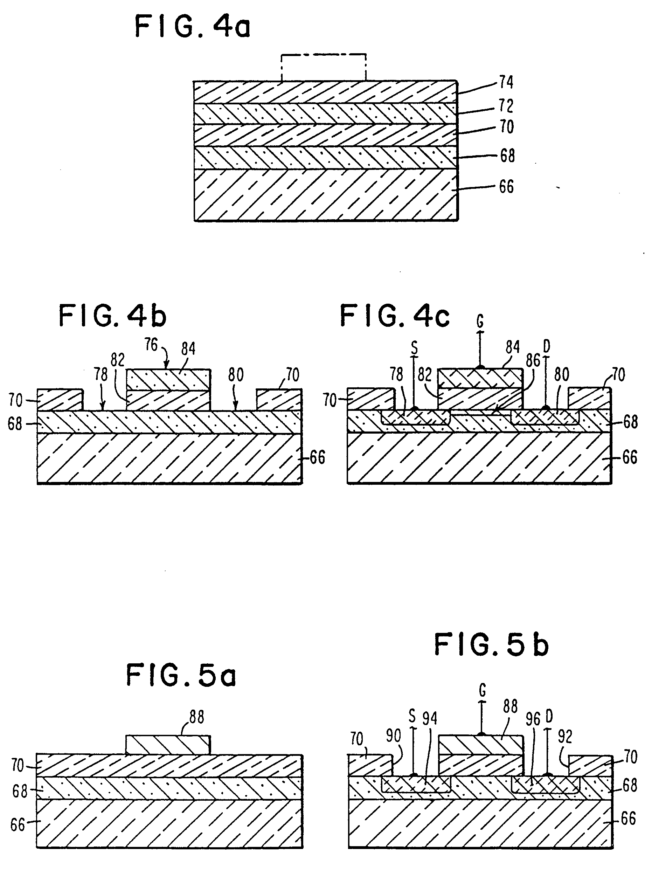

Figures 4a - 4c show the basic fabrication steps for forming a non-inverted gate TFT of the present invention. As shown in Figure 4a, an insulating substrate 66 is provided and the layers 68 of semiconductor material, layer 70 of insulating material, layer 72 of semiconductor material and layer 74 of insulator material are all deposited sequentially by standard deposition techniques. The stacked structure of Figure 4a may be formed sequentially by plasma enhanced CVD in a single pump down. Subsequently, as shown in Figure 4b, a multilayer gate region 76 is defined together with source and drain regions 78 and 80 on either side of the gate region 76. Typically, two photolithographic steps are required to define the gate, source and drain regions. There is no requirement that the alignment of these regions be critical and large tolerances can be built in. In the illustrative embodiment shown in Figure 4b, the gate region 76 includes an insulating layer 82 disposed on the semiconductor layer 68 and a layer 84 of semiconductor material disposed on the insulating layer 82. As noted above, the insulating layers may be one of SiO₂ or Si₃N₄ and the semiconductor layers may be crystalline or amorphous silicon. The insulating substrate may be any intrinsic semiconductor or a glass.

The structure of Figure 4b is then exposed to the refractory metal hexafluoride gas in accordance with the aforementioned Joshi process under suitable conditions such that both the gate layer 84 and the source and drain regions 78 and 80 are converted simultaneously to the refractory metal. As shown in Figure 4c, under reaction 1, layer 84 and regions 78 and 80 are converted to tungsten. Due to the selectivity of the reaction, the conversion of the gate layer 84 to tungsten will stop naturally at the gate insulating layer 82 interface. The depth of the source and drain conversion can further be determined by time exposure. The conversion process is isotropic and proceeds laterally as well as vertically. Thus, a portion of the semiconductor material 68 under the insulator layer 82 will be converted to the refractory metal so that the process will provide self-aligned overlapping source and drain regions with the metal gate. The extent of the overlap will depend upon the depth of conversion of the source and drain regions. Typically, the overlap is in the order of one micron but can potentially be made as small as 1,000 angstroms. The self-alignment of the source and drain electrodes with the metal gate provides the proper alignment without the need for a expensive and time consuming optical alignment techniques presently employed when depositing the metal gates in the prior art devices. This is especially useful when fabricating a multiplicity of TFTs on a large scale (greater than 14 inches) flat panel display matrix arrangement. In addition, the direct contact of the refractory metal source and drain electrodes 78 and 80 to the channel region 86 results in a suitably low resistance once the channel is switched on, which, depending on the application, may be reduced to near zero.

Figures 5a and 5b show an alternative method for fabricating the non-inverted gate TFT of the invention. A semiconductor layer 68 and an insulator layer 70 are deposited onto the glass substrate 66 by PECVD. A metal gate 88 is formed on the insulator 70 by sputtering or evaporation. Typical gate metals are the same as described above for the metal gate of the inverted gate structure. As shown in Figure 5b, the metal gate 88 is then used as an etch mask to etch the source and drain vias 90 and 92. The structure is then exposed to the Joshi process and regions 94 and 96 are selectively converted to the refractory metal. The self-aligned process is highly desirable and possibly even necessary in the fabrication of large area flat panel displays utilizing TFT technology.

The thin film field effect transistors of the invention have a direct or near direct contact of the metallic source and drain electrodes to the channel region, which substantially reduces the series resistance of the transistors. The reduction in resistance significantly enhances device performance. The enhanced performance greatly increases the range of applications of the TFTs of the invention especially for use in flat panel displays.

## Claims

1. A thin film, inverted gate, field effect transistor comprising:
a gate electrode layer (42) disposed on a substrate (40);
a first insulator layer (44) disposed on said substrate and said gate electrode;
a semiconductor layer (46) disposed on said insulator layer;
source and drain electrodes (54', 56') formed within said semiconductor layer of a refractory metal, said source and drain electrodes being spaced apart in the region above said gate electrode;
a second insulator layer (48) disposed on said semiconductor layer extending across the region between said source and drain electrodes.

2. A thin film field effect transistor comprising:
a semiconductor layer (68) disposed on a substrate (66);
a gate insulator layer (70) disposed on said semiconductor layer;
a gate electrode layer (72) disposed on said gate insulator layer; and
source and drain electrodes (78, 80) formed within said semiconductor layer, said source and drain electrodes being spaced apart in a portion of the region below said gate insulator layer;
characterized in that said source and drain electrodes are formed of a refractory metal.

3. The thin film transistor of claim 1 or 2 wherein the semiconductor layer is one of a monocrystalline state, a polycrystalline state or an amorphous state.

4. The thin film transistor of anyone of the claims 1 to 3 wherein the refractory metal is tungsten.

5. The thin film transistor of anyone of the claims 1 to 4 wherein the substrate is glass.

6. The thin film transistor of claim 1 or anyone of the claims 3 to 5 wherein the source and drain electrodes formed within the semiconductor layer contact the insulator layer.

7. The thin film transistor of claim 1 or anyone of the claims 3 to 5 wherein the source and drain electrodes formed within the semiconductor layer are spaced from said first insulator layer (44) by a thin layer of said semiconductor layer.

8. The thin film transistor of claim 1 or anyone of the claims 3 to 7 wherein the spacing between the source and drain electrodes and the first insulator layer (44) is in the range between 10 to 50 nm.

9. A method of fabricating a self-aligned thin film field effect transistor according to claim 2 comprising the steps of:
providing a substrate having a layer of semiconductor material disposed thereon;
forming a multilayer gate region on said semiconductor layer thereby defining source and drain regions of said semiconductor layer on either side of said gate region;
selectively converting by a chemical reaction the source and drain regions of said semiconductor material to a refractory metal to form self-aligned source and drain electrodes spaced apart in a portion of the semiconductor material below said gate regions.

10. The method of claim 9 wherein the multilayer gate region is formed with a first layer of insulator material disposed on said semiconductor layer and a second layer of semiconductor material disposed on said insulator layer, and wherein said second layer of semiconductor material is converted by a chemical reaction to said refractory metal simultaneously with the conversion of said source and drain regions.

11. The method of claim 9 or 10 wherein the multilayer gate region is formed with a first layer of insulator material disposed on said semiconductor layer and a second layer of metal disposed on said first layer thereby forming a metal gate, and wherein said metal gate acts as a mask for defining the source and drain regions.

12. A method of fabricating a thin film inverted gate field effect transistor according to claim 1 comprising the steps of:
providing a substrate having a gate electrode layer disposed thereon and a first insulator layer disposed on said electrode layer and said substrate;
depositing a layer of semiconductor material on said insulator layer;
depositing a second layer of insulating material on said semiconductor layer and etching source and drain vias in said second insulating layer to expose source and drain regions of said semiconductor layer;
selectively converting by a chemical reaction the semiconductor layer exposed by said vias to a refractory metal to thereby form source and drain electrodes within said semiconductor layer, said source and drain electrodes being spaced apart in the region above said gate electrode.

13. A method of claim 12 comprising the steps of:
providing a substrate having a gate electrode layer disposed thereon and a first insulator layer disposed on said electrode layer and said substrate;
depositing a layer of semiconductor material on said insulator layer;
depositing a second layer of insulating material on said semiconductor layer and etching a via in said second insulating layer to expose a region of said semiconductor layer;
selectively converting by a chemical reaction the region of said semiconductor layer exposed by said via to a refractory metal to a depth less than the total thickness thereof;
etching the refractory metal to expose a thin layer of semiconductor material and depositing a third layer of insulating material above the gate electrode to define source and drain regions on either side of said third layer; and
selectively converting the source and drain regions to a refractory metal to form metallic source and drain electrodes.

14. The method of anyone of the claims 9 to 13 wherein the semiconductor layer is converted by a chemical reaction to a refractory metal by exposing the semiconductor layer to a refractory metal hexafluoride gas.

15. The method of claim 14 wherein the metal hexafluoride gas is WF₆ and the source and drain electrodes are converted to W.

16. The method of claim 14 or 15 wherein the layer of semiconductor material has a thickness greater than the thickness at which the reaction between said semiconductor and said refractory metal hexafluoride is self-limiting and wherein the semiconductor layer is exposed to the metal hexafluoride gas under conditions of flow rate, pressure and temperature sufficient to render said reaction no longer self-limiting.

17. The method of anyone of the claims 12 to 16 wherein the entire thickness of the semiconductor layer is converted by a chemical reaction to said refractory metal so that said source and drain electrodes contact said first insulating layer.

18. The method of claim 17 wherein the source and drain electrodes contact channel region within the insulating layer sufficiently to reduce a series resistance therein to near zero.

19. The method of anyone of the claims 12 to 16 wherein less than the entire thickness of the semiconductor layer is converted by a chemical reaction to said refractory metal so that said source and drain electrodes are spaced from said first insulating layer.

## Patentansprüche

1. Ein Dünnfilm-Feldeffekt-Transistor mit invertiertem Gate, folgendes umfassend:
eine Gate-Elektrodenschicht (42), die auf einem Substrat (40) angeordnet ist;
eine erste Isolatorschicht (44), die auf dem genannten Substrat und der genannten Gate-Elektrode angeordnet ist;
eine Halbleiterschicht (46), die auf der genannten Isolatorschicht angeordnet ist;
Quellen- und Senkenelektroden (54', 56'), die innerhalb der genannten Halbleiterschicht aus einem refraktären Metall gebildet werden, wobei die genannten Quellen- und Senkenelektroden in dem Gebiet über der genannten Gate-Elektrode einen Abstand zueinander aufweisen;
eine zweite Isolatorschicht (48), die auf der genannten Halbleiterschicht angeordnet ist und sich über das Gebiet zwischen der genannten Quellen- und Senkenelektrode erstreckt.

2. Ein Dünnfilm-Feldeffekt-Transistor, der folgendes umfaßt:
eine Halbleiterschicht (68), die auf einem Substrat (66) angeordnet ist;
eine Gate-Isolatorschicht (70), die auf der genannten Halbleiterschicht angeordnet ist;
eine Gate-Elektrodenschicht (72), die auf der genannten Gate-Isolatorschicht angeordnet ist; und
Quellen- und Senkenelektroden (78, 80), die innerhalb der genannten Halbleiterschicht gebildet werden, wobei die genannten Quellen- und Senkenelektroden in einem Abschnitt des Gebiets unter der genannten Gate-Isolatorschicht einen Abstand zueinander aufweisen, dadurch gekennzeichnet, daß die genannten Quellen- und Senkenelektroden aus einem refraktären Metall gebildet sind.

3. Der Dünnfilm-Transistor aus Anspruch 1 oder 2, bei dem die Halbleiterschicht einen einkristallinen Zustand, einen mehrkristallinen Zustand oder einen amorphen Zustand aufweisen kann.

4. Der Dünnfilm-Transistor nach einem der Ansprüche 1 bis 3, in welchem es sich bei dem refraktären Metall um Wolfram handelt.

5. Der Dünnfilm-Transistor aus einem der Ansprüche 1 bis 4, in welchem es sich bei dem Substrat um Glas handelt.

6. Der Dünnfilm-Transistor des Anspruchs 1 oder einem der Ansprüche 3 bis 5, in welchem die Quellen- und Senkenelektroden, die innerhalb der Halbleiterschicht gebildet werden, die Isolatorschicht kontaktieren.

7. Der Dünnfilm-Transistor des Anspruchs 1 oder einem der Ansprüche 3 bis 5, in welchem die Quellen- und Senkenelektroden, die innerhalb der Halbleiterschicht gebildet werden, von der genannten ersten Isolatorschicht (44) durch eine dünne Schicht der genannten Halbleiterschicht getrennt sind.

8. Der Dünnfilm-Transistor des Anspruchs 1 oder einem der Ansprüche 3 bis 7, bei dem der Abstand zwischen der Quellen- und der Senkenelektrode und der ersten Isolatorschicht (44) im Bereich 10 bis 50 nm liegt.

9. Eine Methode zur Herstellung eines selbstjustierten Dünnfilm-Feldeffekt-Transistors gemäß Anspruch 2, die folgende Schritte umfaßt:
Herstellen eines Substrats mit einer darauf angeordneten Schicht aus Halbleitermaterial;
Bilden eines mehrschichtigen Gate-Gebiets auf der genannten Halbleiterschicht, wodurch die Quellen- und Senkengebiete der genannten Halbleiterschicht zu beiden Seiten des genannten Gate-Gebiets festgelegt werden;
durch chemische Reaktion selektives Umwandeln der Quellen- und Senkengebiete des genannten Halbleitermaterials in ein refraktäres Metall zur Bildung selbstjustierter Quellen- und Senkenelektroden, die in einem Abschnitt des Halbleitermaterials unter den genannten Gate-Gebieten einen Abstand zueinander aufweisen.

10. Die Methode des Anspruchs 9, in der das mehrschichtige Gate-Gebiet mit einer ersten Schicht aus Isolatormaterial gebildet wird, die auf der genannten Halbleiterschicht angeordnet ist, und einer zweiten Schicht aus Halbleitermaterial, die auf der genannten Isolatorschicht angeordnet ist, und in der die genannte zweite Schicht aus Halbleitermaterial, durch eine chemische Reaktion, gleichzeitig mit der Umwandlung der genannten Quellen- und Senkengebiete in das genannte refraktäre Metall umgewandelt wird.

11. Die Methode des Anspruchs 9 oder 10, in der das mehrschichtige Gate-Gebiet mit einer ersten Schicht Isolatormaterial gebildet wird, die auf der genannten Halbleiterschicht angeordnet ist, und einer zweiten Schicht aus Metall, die auf der genannten ersten Schicht angeordnet ist, wodurch ein Metall-Gate gebildet wird, und in der das genannte Metall-Gate als eine Maske zur Festlegung der Quellen- und Senkengebiete dient.

12. Eine Methode zur Herstellung eines Dünnfilm-Feldeffekt-Transistors mit invertiertem Gate, gemäß Anspruch 1, die folgende Schritte umfaßt:
Herstellen eines Substrats mit einer darauf angeordneten Gate-Elektrodenschicht und einer ersten Isolatorschicht, die auf der genannten Elektrodenschicht und dem genannten Substrat angeordnet ist;
Aufbringen einer Schicht aus Halbleitermaterial auf der genannten Isolatorschicht;
Aufbringen einer zweiten Schicht aus Isolatormaterial auf der genannten Halbleiterschicht und Ätzen von Quellen- und Senkenverbindungslöchern in die genannte zweite Isolier-Schicht, um Quellen- und Senkengebiete der genannten Halbleiterschicht freizulegen;
durch eine chemische Reaktion, selektives Umwandeln der durch die genannten Verbindungslöcher freigelegten Halbleiterschicht in ein refraktäres Metall, um dadurch innerhalb der genannten Halbleiterschicht Quellen- und Senkenelektroden zu bilden, wobei die genannten Quellen- und Senkenelektroden in dem Gebiet über der genannten Gate-Elektrode einen Abstand zueinander aufweisen.

13. Eine Methode nach Anspruch 12, die folgende Schritte umfaßt:
Herstellen eines Substrats mit einer darauf angeordneten Gate-Elektrodenschicht und einer ersten Isolatorschicht, die auf der genannten Elektrodenschicht und dem genannten Substrat angeordnet ist;
Aufbringen einer Schicht aus Halbleitermaterial auf der genannten Isolatorschicht;
Aufbringen einer zweiten Schicht aus isolierendem Material auf der genannten Halbleiterschicht und Ätzen eines Verbindungsloches in die genannte zweite Isolier-Schicht, um ein Gebiet der genannten Halbleiterschicht freizulegen;
durch eine chemische Reaktion, selektives Umwandeln des durch das genannte Verbindungsloch freigelegten Gebiets der genannten Halbleiterschicht in ein refraktäres Metall bis zur einer Tiefe, die unter der Gesamtdicke der Schicht liegt;
Ätzen des refraktären Metalls, um eine dünne Schicht aus Halbleitermaterial freizulegen, und Aufbringen einer dritten Schicht aus isolierendem Material über der Gate-Elektrode, um die Quellen- und Senkengebiete auf beiden Seiten der genannten dritten Schicht festzulegen; und
selektives Umwandeln der Quellen- und Senkengebiete in ein refraktäres Metall, um metallische Quellen- und Senkenelektroden zu bilden.

14. Die Methode nach einem der Ansprüche 9 bis 13, in der die Halbleiterschicht, durch eine chemische Reaktion, in ein refraktäres Metall umgewandelt wird, indem die Halbleiterschicht einem Refraktärmetall-Hexafluoridgas ausgesetzt wird.

15. Die Methode des Anspruches 14, in der es sich bei dem Metall-Hexafluoridgas um WF₆ handelt und die Quellen- und Senkenelektroden in W umgewandelt werden.

16. Die Methode des Anspruchs 14 oder 15, in der die Schicht des Halbleitermaterials eine Dicke aufweist, die größer ist als die Dicke, bei der die Reaktion zwischen dem genannten Halbleiter und dem genannten Refraktärmetall-Hexafluorid eigenbegrenzend ist, und in der die Halbleiterschicht dem Metall-Hexafluoridgas unter Strömungsmengen-, Druck- und Temperaturbedingungen ausgesetzt wird, die ausreichen, um die Eigenbegrenzung der genannten Reaktion aufzuheben.

17. Die Methode nach einem der Ansprüche 12 bis 16, in der die Gesamtdicke der Halbleiterschicht, durch chemische Reaktion, in das genannte refraktäre Metall umgewandelt wird, so daß die genannten Quellen- und Senkenelektroden mit der genannten ersten Isolier-Schicht Kontakt haben.

18. Die Methode des Anspruchs 17, in der die Quellen- und Senkenelektroden ein Kanalgebiet innerhalb der Isolier-Schicht kontaktieren, was ausreicht, um einen Serienwiderstand in dieser auf fast Null zu reduzieren.

19. Die Methode nach einem der Ansprüche 12 bis 16, in der weniger als die Gesamtdicke der Halbleiterschicht durch eine chemische Reaktion in das genannte refraktäre Metall umgewandelt wird, so daß die genannten Quellen- und Senkenelektroden zu der genannten ersten Isolier-Schicht einen Abstand aufweisen.

## Revendications

1. Transistor à effet de champ à grille inversée et à film mince comprenant :
une couche d'électrode de grille (42) déposée sur un substrat (40) ;
une première couche isolante (44) déposée sur ledit substrat et ladite électrode de grille ;
une couche semi-conductrice (46) déposée sur ladite couche isolante ;
des électrodes de source et de drain (54', 56') réalisées en métal réfractaire dans ladite couche semi-conductrice, lesdites électrodes de source et de drain étant séparées l'une de l'autre dans la région au-dessus de ladite électrode de grille ;
une seconde couche isolante (48) déposée sur ladite couche semi-conductrice s'étendant sur la région entre lesdites électrodes de source et de drain.

2. Transistor à effet de champ à film mince comprenant :
une couche semi-conductrice (68) déposée sur un substrat (66) ;
une couche d'isolation de grille (70) déposée sur ladite couche semi-conductrice ;
une couche d'électrode de grille (72) déposée sur ladite couche d'isolation de grille ; et
des électrodes de source et de drain (78, 80) formées dans ladite couche semi-conductrice, lesdites électrodes de source et de drain étant espacées l'une de l'autre dans une partie de la région située sous ladite couche isolante de grille ;
caractérisé en ce que lesdites électrodes de source et de drain sont formées d'un métal réfractaire.

3. Transistor à film mince selon la revendication 1 ou 2 dans lequel la couche semi-conductrice est à l'état monocristallin, à l'état polycristallin, ou à l'état amorphe.

4. Transistor à film mince selon l'une quelconque des revendications 1 à 3 dans lequel le métal réfractaire est du tungstène.

5. Transistor à film mince selon l'une quelconque des revendications 1 à 4 dans lequel le substrat est en verre.

6. Transistor à film mince selon la revendication 1 ou l'une quelconque des revendications 3 à 5 dans lequel les électrodes de source et de drain formées dans la couche semi-conductrice sont en contact avec la couche isolante.

7. Transistor à film mince selon la revendication 1 ou selon l'une quelconque des revendications 3 à 5 dans lequel les électrodes de source et de drain formées dans la couche semi-conductrice sont espacées de ladite première couche isolante (44) par une mince couche dudit semi-conducteur.

8. Transistor à film mince selon la revendication 1 ou selon une quelconque des revendications 3 à 7 dans lequel l'espace entre les électrodes de source et de drain et la première couche isolante (44) est dans une gamme allant de 10 à 50 nm.

9. Procédé de fabrication d'un transistor à effet de champ à film mince auto-aligné selon la revendication 8 comprenant les étapes suivantes :
fourniture d'un substrat comportant une couche de matériau semi-conducteur déposé sur ledit substrat ;
formation d'une région de grille multi-couches sur ladite couche semi-conductrice définissant ainsi des régions de source et de drain dans ladite couche semi-conductrice de chaque côté de la région de grille ;
transformation sélective par réaction chimique des régions de source et de drain dudit matériau semi-conducteur en un métal réfractaire de façon à former des électrodes de source et de drain auto-alignées et séparées dans une partie du matériau semi-conducteur sous lesdites régions de grille.

10. Procédé selon la revendication 9 dans lequel la région de grille multi-couches est formée d'une première couche de matériau isolant déposée sur ladite couche semi-conductrice et une seconde couche de matériau semi-conducteur déposée sur ladite couche isolante, et selon lequel ladite seconde couche de matériau semi-conducteur est transformée par une réaction chimique en un métal réfractaire en même temps que la transformation desdites régions de source et de drain.

11. Procédé selon les revendications 9 ou 10 dans lequel la région de grille multi-couches est formée d'une première couche de matériau isolant déposée sur ladite couche semi-conductrice et une seconde couche de métal déposée sur ladite première couche formant ainsi une grille métallique, et dans lequel ladite grille métallique agit comme un masque pour la définition des régions de source et de drain.

12. Procédé de fabrication d'un transistor à effet de champ à grille inversée à film mince selon la revendication 1 comprenant les étapes suivantes :
fourniture d'un substrat comportant une couche d'électrode de grille déposée sur ledit substrat et une première couche isolante déposée sur ladite couche d'électrode et ledit substrat ;
dépôt d'une couche de matériau semi-conducteur sur ladite couche isolante ;
dépôt d'une seconde couche de matériau isolant sur ladite couche semi-conductrice et gravure de passages de source et de drain dans ladite seconde couche isolante pour exposer les régions de source et de drain de ladite couche semi-conductrice ;
conversion sélective par réaction chimique de la couche semi-conductrice exposée par lesdites ouvertures en un métal réfractaire de façon à former ainsi des électrodes de source et de drain dans ladite couche semi-conductrice, lesdites électrodes de source et de drain étant espacées dans la région située au-dessus de l'électrode de grille.

13. Procédé selon la revendication 12 comprenant les étapes suivantes :
fourniture d'un substrat ayant une couche d'électrode de grille déposée sur ledit substrat et une première couche isolante déposée sur ladite couche d'électrode et ledit substrat ;
dépôt d'une couche de matériau semi-conducteur sur ladite couche isolante ;
dépôt d'une seconde couche de matériau isolant sur ladite couche semi-conductrice et gravure d'une ouverture dans ladite seconde couche isolante de façon à exposer une région de ladite couche semi-conductrice ;
conversion sélective par une réaction chimique de la région de ladite couche semi-conductrice exposée par ladite ouverture en un métal réfractaire d'une profondeur inférieure à l'épaisseur totale ;
gravure du métal réfractaire pour exposer une mince couche de matériau semi-conducteur et déposer une troisième couche de matériau isolant au-dessus de l'électrode de grille pour définir des régions de source et de drain de chaque côté de ladite troisième couche ; et
conversion sélective de régions de source et de drain en métal réfractaire pour former des électrodes métalliques de source et de drain.

14. Procédé selon l'une quelconque des revendications 9 à 13 selon lequel la couche semi-conductrice est transformée par réaction chimique en un métal réfractaire par exposition de la couche semi-conductrice à un gaz d'hexafluorure de métal réfractaire.

15. Procédé selon la revendication 14 dans lequel le gaz d'hexafluorure de métal est du WF₆ et les électrodes de source et de drain sont transformées en W.

16. Procédé selon la revendication 14 ou 15 dans lequel la couche
de matériau semi-conducteur a une épaisseur supérieure à l'épaisseur à laquelle la réaction entre ledit semi-conducteur et ledit hexafluorure de métal réfractaire est auto-limitative, et dans lequel la couche semi-conductrice est exposée au gaz d'hexafluorure de métal dans des conditions de flux, de pression et de température suffisantes pour rendre la réaction non auto-limitative.

17. Procédé selon l'une quelconque des revendications 12 à 16 dans lequel la totalité de l'épaisseur de la couche semi-conductrice est transformée par réaction chimique en ledit métal réfractaire de sorte que les électrodes de source et de drain contactent ladite première couche isolante.

18. Procédé selon la revendication 17 dans lequel les électrodes de source et de drain contactent une région de canal dans la couche isolante de façon suffisante pour réduire une résistance série presque à zéro.

19. Procédé selon l'une quelconque des revendications 12 à 16 dans lequel moins de la totalité de l'épaisseur de la couche semi-conductrice est transformée par procédé chimique en ledit métal réfractaire de sorte que les électrodes de source et de drain soient espacées de ladite première couche isolante.
